# EUROPÄISCHE PATENTSCHRIFT

(11) **EP 0 865 667 B1**
(45) Veröffentlichungstag und Bekanntmachung des Hinweises auf die Patenterteilung: **03.11.1999**
(21) Anmeldenummer: 96946141.7
(22) Anmeldetag: 05.12.1996
(51) Int. Cl.: H01L 21/8246, H01L 27/112

(54) **FESTWERTSPEICHERZELLENANORDNUNG UND VERFAHREN ZU DEREN HERSTELLUNG**
READ-ONLY STORAGE CELL ARRANGEMENT AND METHOD FOR PRODUCING THE SAME
MEMOIRE MORTE ET SON PROCEDE DE PRODUCTION

(30) Priorität: 08.12.1995 DE 19545903
(43) Veröffentlichungstag der Anmeldung: 23.09.1998
(73) Patentinhaber: SIEMENS AKTIENGESELLSCHAFT, 80333 München (DE)
(72) Erfinder: KRAUTSCHNEIDER, Wolfgang, D-83104 Hohenthann (DE); LAU, Frank, D-83052 Bruckmühl (DE); HOFMANN, Franz, D-80995 München (DE)
(86) Internationale Anmeldenummer: DE9602328
(87) Internationale Veröffentlichungsnummer: WO9722139

(56) Entgegenhaltungen:
- DE-A- 19 510 042
- US-A- 5 300 804
- US-A- 5 453 637
- PATENT ABSTRACTS OF JAPAN vol. 018, no. 109 (E-1513), 22.Februar 1994 & JP 05 308135 A (RICOH CO LTD), 19.November 1993,
- PATENT ABSTRACTS OF JAPAN vol. 014, no. 324 (E-0951), 11.Juli 1990 & JP 02 106966 A (SEIKO EPSON CORP), 19.April 1990,

## Beschreibung

Für viele elektronische Systeme werden Speicher benötigt, in die Daten fest eingeschrieben werden. Derartige Speicher werden unter anderem als Festwertspeicher, Lesespeicher oder Read Only Memory bezeichnet.

Für sehr große Datenmengen werden als Lesespeicher vielfach Kunststoffscheiben verwendet, die mit Aluminium beschichtet sind. In der Beschichtung weisen diese Kunststoffscheiben zweierlei punktartige Vertiefungen auf, die den logischen Werten Null und Eins zugeordnet werden. In der Anordnung dieser Vertiefungen ist die Information digital abgespeichert. Derartige Scheiben werden als Kompaktdisc bezeichnet und sind zur digitalen Abspeicherung von Musik verbreitet.

Zum Lesen der auf einer Kompaktdisc gespeicherten Daten wird ein Lesegerät verwendet, in dem die Scheibe mechanisch rotiert. Die punktartigen Vertiefungen werden über eine Laserdiode und eine Photozelle abgetastet. Typische Abtastraten sind dabei 2 x 40 kHz. Auf einer Kompaktdisc können 5 Gbit Informationen gespeichert werden.

Das Lesegerät weist bewegte Teile auf, die mechanischem Verschleiß unterworfen sind, die vergleichsweise viel Volumen benötigen und die nur einen langsamen Datenzugriff erlauben. Das Lesegerät ist darüber hinaus empfindlich gegen Erschütterungen und daher in mobilen Systemen nur begrenzt einsetzbar. Zur Speicherung kleinerer Datenmengen sind Festwertspeicher auf Halbleiterbasis bekannt. Vielfach werden diese als planare integrierte Siliziumschaltung realisiert, in der MOS-Transistoren verwendet werden. Die MOS-Transistoren werden jeweils über die Gateelektrode, die mit der Wortleitung verbunden ist, ausgewählt. Der Eingang des MOS-Transistors ist mit einer Referenzleitung verbunden, der Ausgang mit einer Bitleitung. Beim Lesevorgang wird bewertet, ob ein Strom durch den Transistor fließt oder nicht. Entsprechend wird die gespeicherte Information zugeordnet. Technisch wird die Speicherung der Information meist dadurch bewirkt, daß die MOS-Transistoren durch unterschiedliche Implantation im Kanalgebiet unterschiedliche Einsatzspannungen aufweisen.

Diese Speicher auf Halbleiterbasis erlauben einen wahlfreien Zugriff auf gespeicherte Informationen. Die zum Lesen der Information erforderliche elektrische Leistung ist deutlich kleiner als bei einem Lesegerät mit einem mechanischen Laufwerk. Da zum Lesen der Information kein mechanisches Laufwerk erforderlich ist, entfällt der mechanische Verschleiß und die Empfindlichkeit gegenüber Erschütterungen. Festwertspeicher auf Halbleiterbasis sind daher auch für mobile Systeme einsetzbar.

Zur Erhöhung der Speicherdichte in planaren Siliziumspeichern ist vorgeschlagen worden, die MOS-Transistoren zeilenweise anzuordnen. In jeder Zeile sind die MOS-Transistoren in Reihe verschaltet. Durch zeilenweises Ansteuern im Sinne einer NAND- oder NOR-Architektur werden die MOS-Transistoren ausgelesen. Dazu sind pro Zeile nur zwei Anschlüsse erforderlich, zwischen denen in der Zeile angeordnete MOS-Transistoren in Reihe verschaltet sind. Miteinander verbundene Source/Drain-Gebiete benachbarter MOS-Transistoren können dann als zusammenhängendes dotiertes Gebiet realisiert sein. Dadurch kann der Flächenbedarf pro Speicherzelle auf theoretisch 4F² (F: in der jeweiligen Technologie kleinste herstellbare Strukturgröße) reduziert werden. Eine solche Speicherzellenanordnung ist zum Beispiel aus H. Kawagoe und N. Tsuji, IEEE J. Solid-State Circ., vol. SC-11, P. 360 (1976), bekannt.

JP-A-5 308 135 offenbart eine ROM-Zellenanordnung, die vertikale MOS-Transistoren enthaltende, steifenförmige Gräben aufweist.

Der Erfindung liegt das Problem zugrunde, eine Festwertspeicherzellenanordnung auf Halbleiterbasis anzugeben, bei der eine erhöhte Speicherdichte erzielt wird und die mit wenigen Herstellungsschritten und hoher Ausbeute herstellbar ist. Desweiteren soll ein Verfahren zur Herstellung einer solchen Speicherzellenanordnung angegeben werden.

Dieses Problem wird gelöst durch eine Festwertspeicherzellenanordnung gemäß Anspruch 1 sowie durch ein Verfahren zu deren Herstellung gemäß Anspruch 7. Weitere Ausgestaltungen der Erfindung gehen aus den übrigen Ansprüchen hervor.

Die erfindungsgemaße Festwertspeicherzellenanordnung umfaßt in einem Halbleitersubstrat, vorzugsweise aus monokristallinem Silizium, eine Vielzahl einzelner Speicherzellen. Die Speicherzellen umfassen jeweils mindestens einen MOS-Transistor. Die Speicherzellen sind jeweils in Zeilen angeordnet, die im wesentlichen parallel verlaufen. In einer Hauptfläche des Halbleitersubstrats sind Längsgräben vorgesehen, die im wesentlichen parallel zu den Zeilen verlaufen. Die Zeilen sind jeweils abwechselnd auf der Hauptfläche zwischen benachbarten Längsgräben und auf dem Boden der Längsgraben angeordnet. Quer zu den Zeilen verlaufen Bitleitungen, die jeweils mit Source/Drain-Gebieten von entlang unterschiedlichen Zeilen angeordneten MOS-Transistoren verbunden sind. Oberhalb der Zeilen sind Wortleitungen angeordnet, die jeweils mit den Gateelektroden von entlang einer Zeile angeordneten MOS-Transistoren verbunden sind.

Um die Ausbildung leitender Kanäle zwischen benachbarten Zeilen im Halbleitersubstrat zu verhindern, ist es vorteilhaft, im Halbleitersubstrat zwischen benachbarten Längsgräben dotierte Schichten vorzusehen, die als Kanalstopper wirken.

Die Festwertspeicherzellenanordnung ist mit einem Flächenbedarf pro Speicherzelle von 2F² (F: minimale Strukturgröße in der jeweiligen Technologie) realisierbar. Dazu werden die MOS-Transistoren von entlang einer Zeile angeordneten Speicherzellen in Reihe verschaltet. Miteinander verbundene Source/Drain-Gebiete von entlang einer Zeile benachbarten MOS-Transistoren sind dabei als zusammenhängendes dotiertes Gebiet im Halbleitersubstrat ausgebildet. Entlang einer Bitleitung, das heißt quer zum Verlauf der Längsgräben, verbundene Source/Drain-Gebiete sind dabei über dotierte Gebiete im Halbleitersubstrat miteinander verbunden. Die dotierten Gebiete sind dabei jeweils in den Seitenwänden der Längsgraben angeordnet. Die Bitleitungen werden in dieser Ausführungsform jeweils durch die Source/Drain-Gebiete und die diese verbindenden dotierten Gebiete in den Seitenwanden der Längsgräben gebildet.

Werden die Längsgräben mit einer Grabenweite von F und im Abstand F gebildet und beträgt die Ausdehnung der zusammenhängenden dotierten Gebiete, die jeweils als miteinander verbundene Source/Drain-Gebiete von zwei MOS-Transistoren wirken, F und die Ausdehnung des Kanalgebietes F, so ergibt sich ein Platzbedarf pro Speicherzelle von 2F², weil jedes der zusammenhängenden dotierten Gebiete zwei benachbarten Speicherzellen angehört und weil benachbarte Zeilen von Speicherzellen unmittelbar nebeneinander angeordnet sind. Die Isolation benachbarter Zeilen von Speicherzellen wird durch die Anordnung am Boden des Längsgrabens und auf der Hauptfläche des Halbleitersubstrats zwischen benachbarten Längsgraben sichergestellt.

Es liegt im Rahmen der Erfindung, daß die MOS-Transistoren je nach in der jeweiligen Speicherzelle eingespeicherter Information unterschiedliche Schwellenspannungen aufweisen. Zur Abspeicherung von Daten in digitaler Form weisen die MOS-Transistoren zwei unterschiedliche Schwellenspannungen auf. Soll die Festwertspeicherzellenanordnung für Mehrwertlogik eingesetzt werden, so weisen die MOS-Transistoren je nach eingespeicherter Information mehr als zwei unterschiedliche Schwellenspannungen auf.

Es liegt im Rahmen der Erfindung, unterschiedliche Schwellenspannungen der MOS-Transistoren durch unterschiedliche Kanaldotierungen der MOS-Transistoren zu realisieren.

Gemäß einer Ausführungsform der Erfindung weisen die MOS-Transistoren als Gatedielektrikum eine dielektrische Mehrfachschicht auf. In der dielektrischen Mehrfachschicht ist mindestens eine Schicht vorgesehen, die im Vergleich mit mindestens einer weiteren Schicht in der Mehrfachschicht einen erhöhten Elektroneneinfangquerschnitt aufweist. Vorzugsweise umfaßt die dielektrische Mehrfachschicht eine SiO₂-Schicht, eine Si₃N₄-Schicht und eine SiO₂-Schicht (sogenanntes ONO). Diese Ausführungsform der Festwertspeicherzellenanordnung ist durch Injektion von Elektronen aus dem Kanalbereich der MOS-Transistoren in die Mehrfachschicht einmal programmierbar. Die injizierten Elektronen werden von Haftstellen in der Grenzschicht zwischen SiO₂ und Si₃N₄ festgehalten und erhöhen die Schwellenspannung des MOS-Transistors. Je nach in der jeweiligen Speicherzelle einzuspeichernder Information wird auf diese Weise die Schwellenspannung des jeweiligen MOS-Transistors gezielt verändert.

Vorzugsweise erfolgt die Herstellung der Festwertspeicherzellenanordnung unter Einsatz selbstjustierender Prozeßschritte, so daß der Platzbedarf pro Speicherzelle reduziert werden kann. Zur Herstellung der Festwertspeicherzellenanordnung werden in einer Hauptfläche eines Halbleitersubstrats im wesentlichen parallel verlaufende Längsgraben geätzt. Es werden eine Vielzahl in Zeilen angeordneter Speicherzellen, die jeweils mindestens einen MOS-Transistor umfassen, erzeugt, wobei die Zeilen abwechselnd an der Hauptfläche zwischen benachbarten Längsgräben und am Boden der Längs gräben angeordnet sind. Die Source/Drain-Gebiete der MOS-Transistoren werden durch Implantation erzeugt, wobei eine Source/Drain-Maske verwendet wird, die die Anordnung der Source/Drain-Gebiete der Speicherzellen definiert. Unter Verwendung der Source/Drain-Maske als Implantationsmaske werden nachfolgend durch eine gewinkelte Implantation in den Seitenwänden der Längsgräben dotierte Gebiete gebildet, die entlang unterschiedlichen Zeilen angeordnete Source/Drain-Gebiete miteinander verbinden. Oberhalb der Zeilen werden Wortleitungen erzeugt, die jeweils mit den Gateelektroden von entlang einer Zeile angeordneten MOS-Transistoren verbunden sind. Die über dotierte Gebiete in den Seitenwänden der Längsgräben miteinander verbundenen Source/Drain-Gebiete, die entlang unterschiedlicher Zeilen angeordnet sind, bilden in der Festwertspeicherzellenanordnung Bitleitungen.

Um die Ausbildung leitender Kanäle im Halbleitersubstrat zwischen benachbarten Zeilen zu unterdrücken, ist es vorteilhaft, vor der Bildung der Längsgraben im Halbleitersubstrat eine dotierte Schicht zu erzeugen, die beim Ätzen der Längsgraben durchätzt wird und die in der Festwertspeicherzellenanordnung als Kanalstopper wirkt.

Im folgenden wird die Erfindung anhand eines Ausführungsbeispiels und der Figuren näher erläutert. Die Darstellungen in den Figuren sind nicht maßstäblich.
- Figur 1: zeigt ein Siliziumsubstrat nach einer ersten Kanalimplantation.
- Figur 2: zeigt das Siliziumsubstrat nach einer Grabenatzung und einer zweiten Kanalimplantation.
- Figur 3: zeigt eine Aufsicht auf das Siliziumsubstrat mit einer Source/Drain-Maske nach einer Implantation zur Bildung der Source/Drain-Gebiete und einer gewinkelten Implantation zur Bildung von dotierten Gebieten in den Seitenwänden der Längsgräben.
- Figur 4: zeigt den in Figur 3 mit IV-IV bezeichneten Schnitt durch das Siliziumsubstrat.
- Figur 5: zeigt den in Figur 3 mit V-V bezeichneten Schnitt durch das Siliziumsubstrat.
- Figur 6: zeigt einen Schnitt durch das Siliziumsubstrat nach Bildung eines Gatedielektrikums, Abscheidung einer leitfähigen Schicht und einer Si₃N₄-Schicht.
- Figur 7: zeigt einen Schnitt durch das Siliziumsubstrat nach Bildung von Si₃N₄-Spacern und einer Oxidmaske zur Strukturierung der leitfähigen Schicht.
- Figur 8: zeigt einen Schnitt durch das Siliziumsubstrat nach Bildung von Wortleitungen durch Strukturierung der leitfähigen Schicht.
- Figur 9: zeigt den in Figur 8 mit IX-IX bezeichneten Schnitt.
- Figur 10: zeigt den in Figur 8 mit X-X bezeichneten Schnitt.
- Figur 11: zeigt ein Schaltbild der Festwertspeicherzellenanordnung.

Zur Herstellung einer Festwertspeicherzellenanordnung in einem Substrat 1 aus zum Beispiel monokristallinem Silizium wird zunächst an einer Hauptfläche 2 des Substrats 1 eine Isolationsstruktur erzeugt, die den Bereich für die Festwertspeicherzellenanordnung definiert (nicht dargestellt) und die gleichzeitig aktive Gebiete für eine Peripherie der Festwertspeicherzellenanordnung definieren kann. Die Isolationsstruktur wird zum Beispiel in einem LOCOS-Prozeß oder in einem Shallow Trench Isolation-Prozeß gebildet. Das Substrat 1 ist zum Beispiel p-dotiert mit einer Dotierstoffkonzentration von 5 x 10¹⁵ cm⁻³.

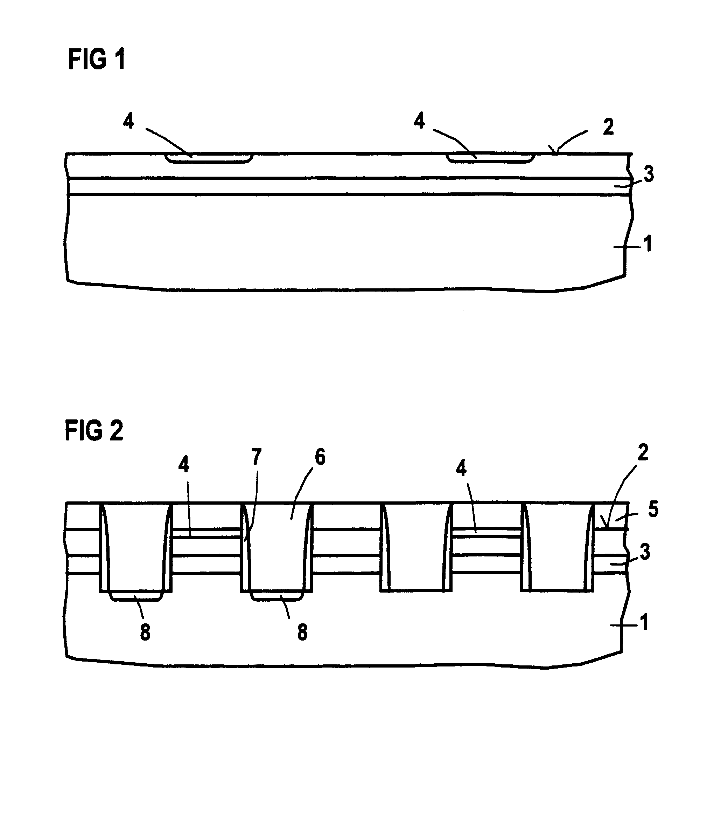

Anschließend wird eine Implantation mit Bor durchgeführt zur Bildung einer Channel-Stop-Schicht 3. Die Borimplantation erfolgt mit einer Dosis von zum Beispiel 6 x 10¹³ cm⁻² und einer Energie von zum Beispiel 120 keV. Dadurch wird die Channel-Stop-Schicht 3 in einer Tiefe von zum Beispiel 0,3 µm unterhalb der Hauptfläche 2 in einer Dicke von 0,3 µm hergestellt (siehe Figur 1).

Mit Hilfe eines photolithographischen Verfahrens werden dann Bereiche für die Depletion-Kanäle von MOS-Transistoren definiert. Mit Hilfe einer ersten Kanalimplantation mit Arsen mit einer Energie von 50 keV und einer Dosis von zum Beispiel 4 x 10¹³ cm⁻² werden die Depletion-Kanäle 4 gebildet. Die Ausdehnung der Depletion-Kanäle 4 parallel zur Hauptfläche 2 beträgt bei Verwendung einer 0,4 µm Technologie zum Beispiel 0,6 µm x 0,6 µm.

Durch Abscheidung einer SiO₂-Schicht in einer Dicke von zum Beispiel 200 nm mit Hilfe eines TEOS-Verfahrens wird durch Strukturierung der SiO₂-Schicht mit Hilfe photolithographischer Verfahren eine Grabenmaske 5 gebildet (siehe Figur 2).

Durch anisotropes Ätzen zum Beispiel mit Cl₂ werden unter Verwendung der Grabenmaske 5 als Ätzmaske Längsgräben 6 geätzt. Die Längsgräben 6 weisen eine Tiefe von zum Beispiel 0,6 µm auf. Die Längsgräben 6 reichen bis in das Substrat 1 hinein, sie durchtrennen die Channel-Stop-Schicht 3. Die Breite der Depletion-Kanäle 4 wird bei der Ätzung der Längsgraben 6 eingestellt. Daher ist die Justierung der Grabenmaske 5 relativ zu den Depletion-Kanälen 4 unkritisch.

Durch Abscheidung einer weiteren SiO₂-Schicht in einem TEOS-Verfahren und anschließendes anisotropes Ätzen werden an den Seitenwänden der Längsgräben 6 Spacer 7 aus SiO₂ gebildet. Mit Hilfe eines photolithographischen Verfahrens werden anschließend Bereiche für die Depletion-Kanäle für MOS-Transistoren, die nachfolgend am Boden der Längsgraben 6 hergestellt werden, definiert. Mit einer zweiten Kanalimplantation mit zum Beispiel Arsen und einer Energie von zum Beispiel 50 keV und einer Dosis von zum Beispiel 4 x 10¹³ cm⁻² werden am Boden der Längsgräben 6 Depletion-Kanäle 8 erzeugt. Die Bereiche zwischen benachbarten Längsgräben 6 sind dabei durch die Grabenmaske 5 und die Spacer 7 maskiert. Die Justierung bei der Definition der Depletion-Kanäle 8 ist daher unkritisch. Bezüglich der Seitenwände der Längsgräben 6 ist die zweite Kanalimplantation selbstjustiert.

Anschließend wird die Grabenmaske 5 naßchemisch zum Beispiel mit NH₄F/HF entfernt. Dabei werden auch die Spacer 7 entfernt.

Auf die Siliziumoberfläche wird eine dünne SiO₂-Schicht 9 in einer Dicke von zum Beispiel 20 nm aufgewachsen. Die dünne SiO₂-Schicht 9 verbessert im Sinne eines sacrificial Oxide die Siliziumoberfläche.

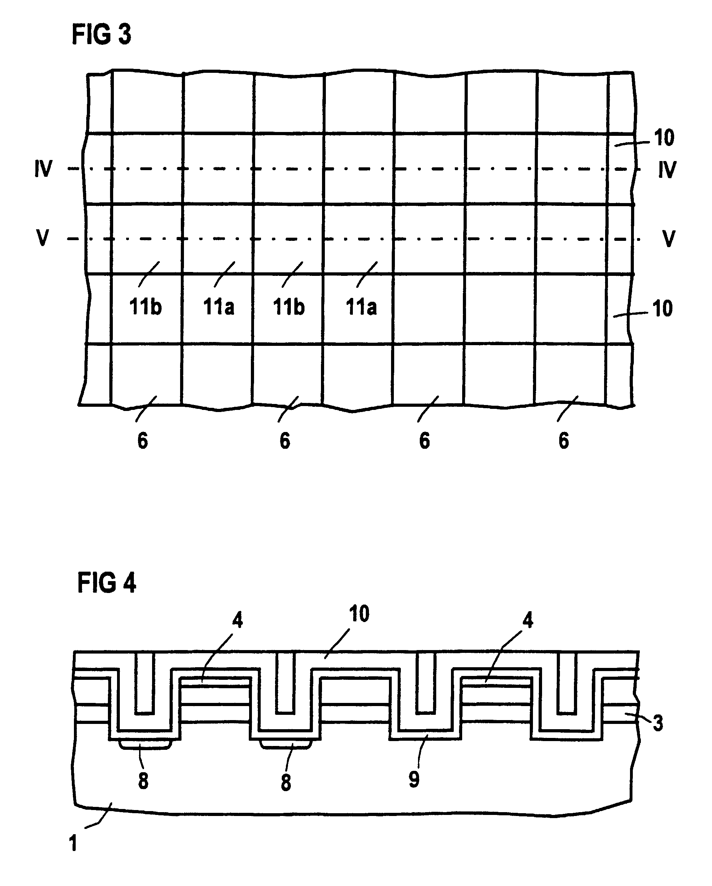

Anschließend wird ganzflächig eine Polysiliziumschicht abgeschieden. Die Polysiliziumschicht wird in einer Dicke von zum Beispiel 500 nm erzeugt. Sie ist zum Beispiel intrinsisch dotiert. Mit Hilfe photolithographischer Prozeßschritte wird durch Strukturierung der Polysiliziumschicht eine Source/Drain-Maske 10 gebildet (siehe Figur 3, Figur 4, Figur 5). Die Source/Drain-Maske 10 definiert die Anordnung nachfolgend herzustellender Source/Drain-Gebiete. Sie weist Polysiliziumstreifen auf, die die Siliziumoberfläche jeweils in den Bereichen abdecken, in denen im folgenden Kanalbereiche für MOS-Transistoren entstehen.

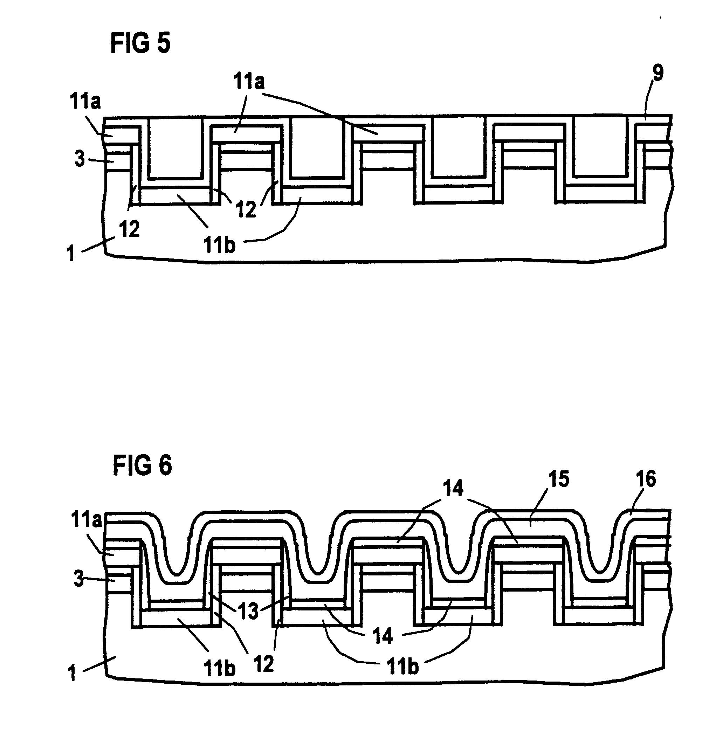

Durch eine Implantation mit Arsen mit einer Energie von ca. 80 keV und einer Dosis von ca. 5 x 10¹⁵ cm⁻² werden obere Source/Drain-Gebiete 11a im Bereich der Hauptfläche 2 jeweils zwischen benachbarten Längsgraben 6 und untere Source/Drain-Gebiete 11b am Boden der Längsgräben 6 gebildet. Die Implantation erfolgt im wesentlichen senkrecht zur Hauptfläche 2 (siehe Figur 3 und Figur 5).

Durch eine Ionenimplantation mit einem Neigungswinkel von zum Beispiel 40° werden in den Seitenwänden der Längsgräben 6 dotierte Gebiete 12 gebildet, die jeweils ein oberes Source/Drain-Gebiet lla mit einem unteren Source/Drain-Gebiet llb miteinander verbinden (siehe Figur 5). Die gewinkelte Implantation erfolgt zum Beispiel mit Arsen mit einer Energie von 5 x 10¹⁵ cm⁻² und einer Dosis von 5 x 10¹⁵ cm⁻².

Anschließend wird die Source/Drain-Maske 10 durch eine trokkene oder naße Ätzung, die selektiv zu SiO₂ Polysilizium angreift, entfernt. Dabei wirkt die dünne SiO₂-Schicht 9 als Ätzstop. Die Source/Drain-Maske 10 wird zum Beispiel naß mit Polysiliziumätze (HF/HNO₃/H₂O) oder trocken mit HBr und Cl₂ entfernt.

Anschließend wird die dünne SiO₂-Schicht 9 zum Beispiel mit Flußsaure (HF) entfernt.

Durch Abscheidung einer SiO₂-Schicht in einem TEOS-Verfahren und anschließendes anisotropes Ätzen werden an den Seitenwänden der Längsgräben 6 SiO₂-Spacer 13 gebildet (siehe Figur 6).

Durch thermische Oxidation wird ein Gatedielektrikum 14 aus zum Beispiel SiO₂ in einer Dicke von zum Beispiel 10 nm gebildet. Anschließend wird ganzflächig eine oxidierbare leitfähige Schicht 15 in einer Dicke von zum Beispiel 100 bis 200 nm erzeugt. Die oxidierbare leitfähige Schicht 15 wird vorzugsweise aus dotiertem Polysilizium gebildet. Alternativ kann die oxidierbare leitfähige Schicht 15 aus einem Metallsilizid oder einer Kombination aus dotiertem Polysilizium und Silizid bestehen.

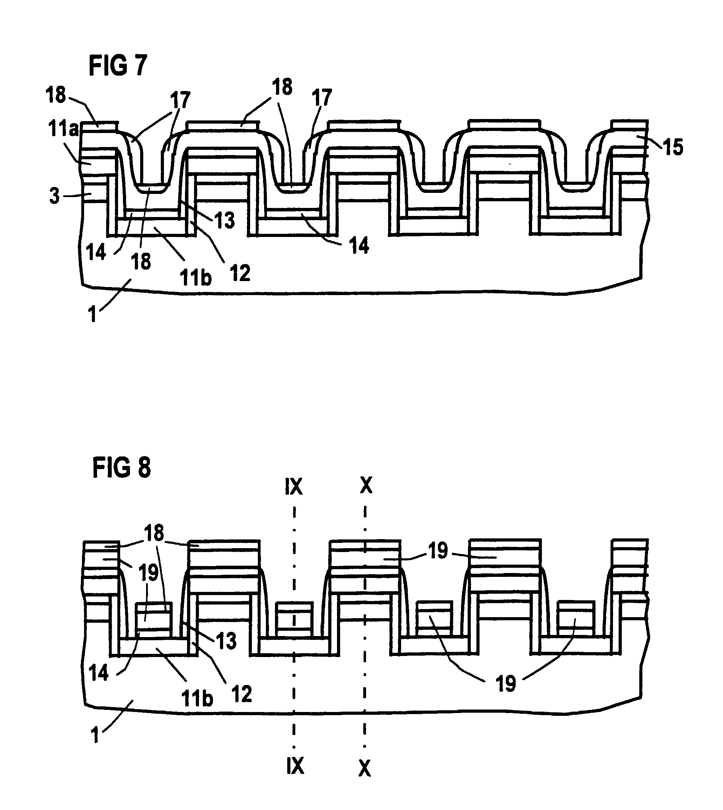

Es wird ganzflächig eine Si₃N₄-Schicht 16 in einer Dicke von zum Beispiel 30 bis 80 nm abgeschieden. Durch anisotropes Ätzen werden planare Teile der Si₃N₄-Schicht 16 entfernt und Si₃N₄-Spacer 17 gebildet. Dabei wird die Oberfläche der oxidierbaren leitfähigen Schicht 15 in planaren Bereichen freigelegt. Die Si₃N₄-Spacer 17 decken die oxidierbare leitfähige Schicht 15 im Bereich der Seitenwände der Längsgraben 6 ab (siehe Figur 7).

Anschließend werden freiliegende Bereiche der oxidierbaren leitfähigen Schicht 15 oxidiert. Die Si₃N₄-Spacer 17 wirken als Oxidationsmaske und erlauben die selektive Oxidation in den planaren Bereichen der oxidierbaren leitfähigen Schicht 15. Dabei wird eine Oxidmaske 18 gebildet, die die planaren Bereiche der oxidierbaren leitfähigen Schicht 15 bedeckt.

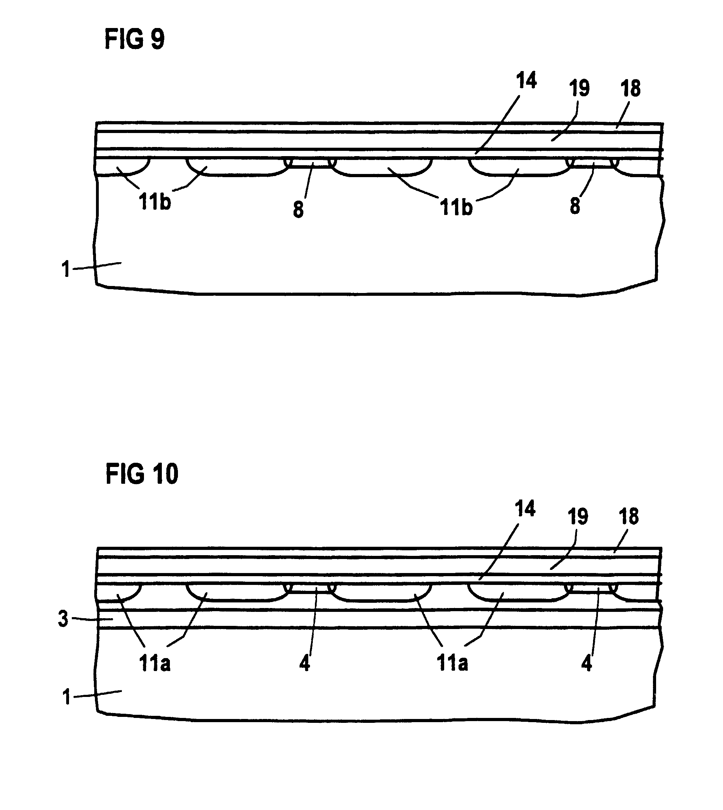

Anschließend werden die Si₃N₄-Spacer 17 entfernt. In einem Ätzprozeß, der die oxidierbare leitfähige Schicht 15 selektiv zu der Oxidmaske 18 angreift, wird die oxidierbare leitfähige Schicht 15 strukturiert. Dabei entstehen am Boden der Längsgraben 6 sowie zwischen benachbarten Längsgraben 6 parallel zu den Längsgräben 6 verlaufende Wortleitungen 19 (siehe Figur 8, Figur 9 und Figur 10). Durch die selektive Oxidation zur Bildung der Oxidmaske 18 ist es möglich, selbstjustiert zum Verlauf der Längsgräben 6 die Wortleitungen 19 zu strukurieren, deren Breite insbesondere am Boden der Längsgräben 6 geringer als die minimale Strukturgröße F ist.

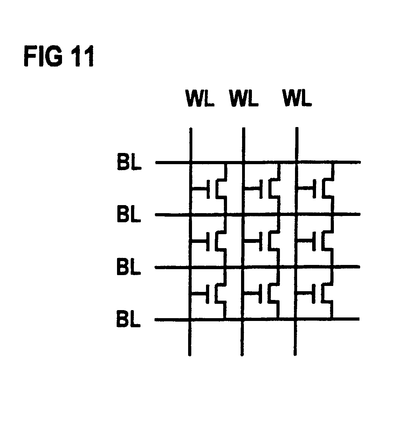

Die Festwertspeicherzellenanordnung ist in einer NOR-Konfiguration verschaltet (siehe Figur 11). Diese Schaltungsarchitektur ermöglicht innerhalb kurzer Zeitkonstanten einen Zugriff auf jede einzelne Speicherzelle. In Figur 11 sind die Wortleitungen mit WL, die Bitleitungen mit BL bezeichnet.

Die Festwertspeicherzellenanordnung wird fertiggestellt durch Abscheidung eines Zwischenoxids. Anschließend werden Kontaktlöcher geätzt, deren Seitenwände mit isolierenden Spacern versehen werden und die zum Beispiel mit Wolfram aufgefüllt werden. Abschließend wird durch Abscheidung einer Metallschicht und Strukturierung der Metallschicht eine Metallisierungsebene erzeugt (nicht dargestellt).

Das Gatedielektrikum 14 kann alternativ aus einer Schichtenfolge SiO₂, Si₃N₄ und SiO₂ (ONO) gebildet werden. In diesem Fall kann die Festwertspeicherzellenanordnung einmal programmiert werden durch Elektroneninjektion aus dem Kanalbereich der MOS-Transistoren in das Gatedielektrikum. Im Gatedielektrikum eingefangene Elektronen erhöhen die Schwellenspannung des MOS-Transistors. In diesem Fall entfallen die beiden Kanalimplantationen zur Einstellung unterschiedlicher Schwellenspannungen.

Durch geeignete Wahl der Spannungsbedingungen während der Elektroneninjektion lassen sich unterschiedliche Schwellenspannungen einstellen, um mehrere logische Werte darzustellen.

## Patentansprüche

1. Festwertspeicherzellenanordnung,
- bei der eine Vielzahl einzelner Speicherzellen in einem Halbleitersubstrat (1) vorgesehen sind,
- bei der die Speicherzellen jeweils in im wesentlichen parallel verlaufenden Zeilen angeordnet sind,
- bei der in einer Hauptfläche (2) des Halbleitersubstrats (1) Längsgräben (6) vorgesehen sind, die im wesentlichen parallel zu den Zeilen verlaufen,
- bei der die Zeilen jeweils abwechselnd auf der Hauptfläche (2) zwischen benachbarten Längsgräben (6) und auf dem Boden der Längsgräben (6) angeordnet sind,
- bei der die Speicherzellen jeweils mindestens einen MOS-Transistor umfassen, dessen Kanallänge parallel zu den Zeilen ausgerichtet ist,
- bei der quer zu den Zeilen Bitleitungen verlaufen, die jeweils mit Source/Drain-Gebieten (11a, 11b) von entlang unterschiedlichen Zeilen angeordneten MOS-Transistoren verbunden sind,
- bei der oberhalb der Zeilen Wortleitungen (19) angeordnet sind, die jeweils mit den Gateelektroden von entlang einer Zeile angeordneten MOS-Transistoren verbunden sind.

2. Festwertspeicherzellenanordnung nach Anspruch 1, bei der im Halbleitersubstrat (1) zwischen benachbarten Längsgräben (6) jeweils dotierte Schichten (3) vorgesehen sind, die die Ausbildung leitender Kanäle zwischen benachbarten Zeilen im Halbleitersubstrat (1) verhindern.

3. Festwertspeicherzellenanordnung nach Anspruch 1 oder 2,
- bei der die MOS-Transistoren von entlang einer Zeile angeordneten Speicherzellen in Reihe verschaltet sind,
- bei der miteinander verbundene Source/Drain-Gebiete von entlang einer Zeile benachbarten MOS-Transistoren als zusammenhängendes dotiertes Gebiet (11a bzw. 11b) im Halbleitersubstrat (1) ausgebildet sind,
- bei der die mit einer Bitleitung verbundenen, entlang unterschiedlichen Zeilen angeordneten Source/Drain-Gebiete (11a, 11b) über dotierte Gebiete (12) miteinander verbunden sind, die jeweils in den Seitenwänden der Längsgräben (6) angeordnet sind.

4. Festwertspeicherzellenanordnung nach einem der Ansprüche 1 bis 3,
bei der die MOS-Transistoren je nach in der jeweiligen Speicherzelle eingespeicherter Information unterschiedliche Schwellenspannungen aufweisen.

5. Festwertspeicherzellenanordnung nach einem der Ansprüche 1 bis 3,
bei der die MOS-Transistoren als Gatedielektrikum (14) eine dielektrische Mehrfachschicht umfassen mit mindestens einer Schicht, die im Vergleich mit mindestens einer weiteren Schicht einen erhöhten Elektroneneinfangsquerschnitt aufweist.

6. Festwertspeicherzellenanordnung nach Anspruch 5, bei der die Mehrfachschicht mindestens eine SiO₂-Schicht und mindestens eine Si₃N₄-Schicht umfaßt.

7. Verfahren zur Herstellung einer Festwertspeicherzellenanordnung,
- bei dem in einer Hauptfläche (2) eines Halbleitersubstrats (1) im wesentlichen parallel verlaufende Längsgräben (6) geätzt werden,
- bei dem eine Vielzahl in Zeilen angeordneter Speicherzellen, die jeweils mindestens einen MOS-Transistor umfassen, dessen Kanallänge parallel zu den Zeilen ausgerichtet ist, erzeugt wird, wobei die Zeilen abwechselnd an der Hauptfläche (2) zwischen benachbarten Längsgräben (6) und am Boden der Längsgräben (6) angeordnet sind,
- bei dem eine Source/Drain-Maske (10) erzeugt wird, die die Anordnung der Source/Drain-Gebiete (11a, 11b) der Speicherzellen definiert,
- bei dem die Source/Drain-Gebiete (11a, 11b) durch Implantation erzeugt werden,
- bei dem unter Verwendung der Source/Drain-Maske (10) als Implantationsmaske durch eine gewinkelte Implantation in den Seitenwänden der Längsgräben (6) dotierte Gebiete (12) gebildet werden, die entlang unterschiedlicher Zeilen angeordnete Source/Drain-Gebiete (11a, 11b) miteinander verbinden,
- bei dem oberhalb der Zeilen Wortleitungen (19) erzeugt werden, die jeweils mit den Gateelektroden von entlang einer Zeile angeordneten MOS-Transistoren verbunden sind.

8. Verfahren nach Anspruch 7,
bei dem vor der Bildung der Längsgräben (6) im Halbleitersubstrat (1) eine dotierte Schicht (3) erzeugt wird, die beim Ätzen der Längsgraben (6) durchätzt wird und die die Ausbildung leitender Kanäle im Halbleitersubstrat (1) zwischen benachbarten Zeilen verhindert.

9. Verfahren nach Anspruch 7 oder 8,
bei dem die MOS-Transistoren mit einer dielektrischen Mehrfachschicht als Gatedielektrikum (14) erzeugt werden, die mindestens eine Schicht mit einem in bezug auf mindestens eine weitere Schicht in der Mehrfachschicht erhöhten Elektroneneinfangquerschnitt aufweist.

10. Verfahren nach Anspruch 9,
bei dem die Mehrfachschicht mindestens eine Schicht aus SiO₂ und eine Schicht aus Si₃N₄ umfaßt.

11. Verfahren nach Anspruch 7 oder 8,
- bei dem vor der Ätzung der Längsgräben (6) eine erste Kanalimplantation zur Einstellung der Schwellenspannung der MOS-Transistoren, die an der Hauptfläche (2) zwischen benachbarten Längsgräben (6) angeordnet sind, durchgeführt wird,
- bei dem nach der Ätzung der Längsgräben (6) eine zweite Kanalimplantation zur Einstellung der Schwellenspannung der MOS-Transistoren, die am Boden der Längsgräben (6) angeordnet sind, durchgeführt wird, wobei die Hauptfläche (2) zwischen benachbarten Längsgräben (6) maskiert ist.

12. Verfahren nach Anspruch 11,
- bei dem die Ätzung der Längsgräben (6) unter Verwendung einer SiO₂ enthaltenden Grabenmaske (5) als Ätzmaske erfolgt,
- bei dem die SiO₂ enthaltende Grabenmaske (5) bei der zweiten Kanalimplantation die Hauptfläche (2) zwischen benachbarten Längsgräben (6) maskiert,
- bei dem die Grabenmaske (5) nach der zweiten Kanalimplantation entfernt wird.

13. Verfahren nach einem der Ansprüche 7 bis 12,
- bei dem zur Bildung der Wortleitungen (19) nach Entfernen der Source/Drain-Maske (10), nach Bildung von isolierenden Spacern (13) an den Seitenwänden der Längsgräben (6) und nach Erzeugung eines Gatedielektrikums (14) ganzflächig eine oxidierbare leitfähige Schicht (15) und darauf eine Siliziumnitridschicht (16) abgeschieden werden,
- bei dem durch anisotropes Ätzen aus der Siliziumnitridschicht (16) Siliziumnitridspacer (17) gebildet werden,
- bei dem freiliegende Bereiche der leitfähigen Schicht (15) durch Oxidation mit einer Oxidmaske (18) versehen werden,
- bei dem die Siliziumnitridspacer (17) entfernt werden,
- bei dem die Wortleitungen (19) durch Strukturieren der leitfähigen Schicht (15) in einem Ätzprozeß, in dem die Oxidmaske (18) als Ätzmaske verwendet wird, gebildet werden.

## Claims

1. Read-only memory cell arrangement,
- in which a multiplicity of individual memory cells are provided in a semiconductor substrate (1),
- in which the memory cells are each arranged in rows which run essentially parallel,
- in which longitudinal trenches (6), which run essentially parallel to the rows, are provided in a main area (2) of the semiconductor substrate (1),
- in which the rows are arranged in each case alternately on the main area (2) between neighbouring longitudinal trenches (6) and on the bottom of the longitudinal trenches (6),
- in which the memory cells each comprise at least one MOS transistor whose channel length is aligned parallel to the rows,
- in which bit lines run transversely with respect to the rows and are each connected to source/drain regions (11a, 11b) of MOS transistors arranged along different rows,
- in which word lines (19) are arranged above the rows and are each connected to the gate electrodes of MOS transistors arranged along a row.

2. Read-only memory cell arrangement according to Claim 1,
in which doped layers (3) are provided in the semiconductor substrate (1) in each case between neighbouring longitudinal trenches (6), which doped layers prevent conductive channels being formed between neighbouring rows in the semiconductor substrate (1).

3. Read-only memory cell arrangement according to Claim 1 or 2,
- in which the MOS transistors of memory cells arranged along a row are connected in series,
- in which source/drain regions, connected to one another, of neighbouring MOS transistors along a row are designed as a coherent doped region (11a and/or 11b) in the semiconductor substrate (1),
- in which the source/drain regions (11a, 11b) which are connected to a bit line and are arranged along different rows are connected to one another via doped regions (12) arranged in each of the side walls of the longitudinal trenches (6).

4. Read-only memory cell arrangement according to one of Claims 1 to 3,
in which the MOS transistors have different threshold voltages depending on the information stored in the respective memory cell.

5. Read-only memory cell arrangement according to one of Claims 1 to 3,
in which the MOS transistors comprise, as gate dielectric (14), a dielectric multilayer coating, having at least one layer which has an increased electron capture cross-section compared with at least one further layer.

6. Read-only memory cell arrangement according to Claim 5,
in which the multilayer coating comprises at least one SiO₂ layer and at least one Si₃N₄ layer.

7. Method for the production of a read-only memory cell arrangement,
- in which longitudinal trenches (6) running essentially parallel are etched in a main area (2) of a semiconductor substrate (1),
- in which a multiplicity of memory cells which are arranged in rows and each comprise at least one MOS transistor whose channel length is aligned parallel to the rows is produced, the rows being arranged alternately on the main area (2) between neighbouring longitudinal trenches (6) and on the bottom of the longitudinal trenches (6),
- in which a source/drain mask (10) is produced which defines the arrangement of the source/drain regions (11a, 11b) of the memory cells,
- in which the source/drain regions (11a, 11b) are produced by implantation,
- in which, using the source/drain mask (10) as an implantation mask, doped regions (12) are formed by angled implantation in the side walls of the longitudinal trenches (6), which doped regions connect together source/drain regions (11a, 11b) arranged along different rows,
- in which word lines (19), which are each connected to the gate electrodes of MOS transistors arranged along a row, are produced above the rows.

8. Method according to Claim 7,
in which a doped layer (3) is produced prior to the formation of the longitudinal trenches (6) in the semiconductor substrate (1), which doped layer (3) is etched through during the etching of the longitudinal trenches (6) and prevents conductive channels being formed in the semiconductor substrate (1) between neighbouring rows.

9. Method according to Claim 7 or 8,
in which the MOS transistors are produced with a dielectric multilayer coating as gate dielectric (14) which has at least one layer having an increased electron capture cross-section in relation to at least one further layer in the multilayer coating.

10. Method according to Claim 9,
in which the multilayer coating comprises at least one layer of SiO₂ and a layer of Si₃N₄.

11. Method according to Claim 7 or 8,
- in which before the longitudinal trenches (6) are etched, a first channel implantation is carried out for the purpose of setting the threshold voltage of the MOS transistors which are arranged on the main area (2) between neighbouring longitudinal trenches (6),
- in which after the longitudinal trenches (6) have been etched, a second channel implantation is carried out for the purpose of setting the threshold voltage of the MOS transistors which are arranged on the bottom of the longitudinal trenches (6), the main area (2) between neighbouring longitudinal trenches (6) being masked.

12. Method according to Claim 11,
- in which the longitudinal trenches (6) are etched using a trench mask (5) containing SiO₂ as an etching mask,
- in which the trench mask (5) containing SiO₂ masks the main area (2) between neighbouring longitudinal trenches (6) during the second channel implantation,
- in which the trench mask (5) is removed after the second channel implantation.

13. Method according to one of Claims 7 to 12,
- in which, in order to form the word lines (19), after the removal of the source/drain mask (10), after the formation of insulating spacers (13) on the side walls of the longitudinal trenches (6) and after the production of a gate dielectric (14), an oxidizable conductive layer (15) and, on top of the latter, a silicon nitride layer (16) are deposited over the whole area,
- in which silicon nitride spacers (17) are formed from the silicon nitride layer (16) by anisotropic etching,
- in which uncovered regions of the conductive layer (15) are provided with an oxide mask (18) by dint of oxidation,
- in which the silicon nitride spacers (17) are removed,
- in which the word lines (19) are formed by structuring the conductive layer (15) in an etching process in which the oxide mask (18) is used as an etching mask.

## Revendications

1. Dispositif cellulaire à mémoires mortes
- dans lequel une pluralité de cellules de mémoire est prévue dans un substrat semi-conducteur (1),
- dans lequel les cellules de mémoire sont disposées respectivement en lignes essentiellement parallèles,
- dans lequel sont prévus, sur une surface principale (2) du substrat semi-conducteur (1), des sillons longitudinaux (6) qui sont essentiellement parallèles aux lignes,
- dans lequel les lignes sont disposées altemativement sur la surface principale (2) entre des sillons longitudinaux voisins (6) et sur le fond des sillons longitudinaux (6),
- dans lequel les cellules de mémoire comprennent chacune au moins un transistor MOS, dont la longueur de canal est orientée parallèlement aux lignes,
- dans lequel sont disposés, perpendiculairement aux lignes, des conducteurs de bits qui sont reliés un par un à des zones source/drain (11a, 11b) de transistors MOS disposés le long de lignes différentes,
- dans lequel, au-dessus des lignes, sont disposés des conducteurs de mots (19) qui sont reliés respectivement aux grilles des transistors MOS disposés le long d'une ligne.

2. Dispositif cellulaire à mémoires mortes selon la revendication 1
dans lequel sont prévues, dans le substrat semi-conducteur (1), entre sillons longitudinaux voisins (6), respectivement des couches dopées (3) qui empêchent la formation de canaux conducteurs entre lignes voisines dans le substrat semi-conducteur (1).

3. Dispositif cellulaire à mémoires mortes selon la revendication 1 ou 2
- dans lequel les transistors MOS des cellules de mémoire disposées le long d'une ligne sont branchés en série,
- dans lequel des zones source/drain, reliées l'une à l'autre, des transistors MOS voisins le long d'une ligne, sont formées, dans le substrat (1), comme zone dopée cohérente (11a et 11b),
- dans lequel les zones source/drain (11a, 11b), disposées le long de lignes différentes et reliées à un conducteur de bits, sont reliées l'une à l'autre par l'intermédiaire de zones dopées (12) qui sont respectivement placées dans les parois latérales des sillons longitudinaux (6).

4. Dispositif cellulaire à mémoires mortes selon l'une des revendications 1 à 3
dans lequel les transistors MOS ont des tensions de seuil différentes en fonction de l'information enregistrée dans la cellule de mémoire respective.

5. Dispositif cellulaire à mémoires mortes selon l'une des revendications 1 à 3
dans lequel les transistors MOS comprennent, comme diélectrique de grille (14) une couche diélectrique multiple avec au moins une couche qui comporte, par comparaison à au moins une autre couche, une section de capture des électrons plus importante.

6. Dispositif cellulaire à mémoires mortes selon la revendication 5
dans lequel la couche multiple comprend au moins une couche de SiO₂ et au moins une couche de Si₃N₄.

7. Procédé pour la fabrication d'un dispositif cellulaire à mémoires mortes
- au cours duquel, sur une surface principale (2) d'un substrat semiconducteur (1), des sillons longitudinaux (6) sont gravés avec un parcours essentiellement parallèles entre eux,
- au cours duquel est générée une pluralité de cellules de mémoire disposées en lignes, qui comprennent chacune au moins un transistor MOS dont la longueur de canal est orientée parallèlement aux lignes, les lignes étant disposées alternativement entre les sillons longitudinaux voisins (6) sur la surface principale (2) et au fond des sillons longitudinaux (6),
- au cours duquel est produit un masque source/drain (10) qui définit la disposition des zones source/drain (11a, 11b) des cellules de mémoire,
- au cours duquel les zones source/drain (11a, 11b) sont produites par implantation,
- au cours duquel, en utilisant un masque source/drain (10) comme masque d'implantation, on forme, grâce à une implantation courbe dans les parois latérales des sillons longitudinaux (6), des zones dopées (12) qui relient l'une à l'autre les zones source/drain (11a, 11b) disposées le long de lignes différentes,
- au cours duquel, au dessus des lignes, sont générés des conducteurs de mots (19) qui sont reliés respectivement aux grilles des transistors MOS disposés le long d'une ligne.

8. Procédé selon la revendication 7
au cours duquel, avant la formation des sillons longitudinaux (6) dans le substrat semi-conducteur (1), est générée une couche dopée (3) qui est complètement décapée lors de la gravure des sillons longitudinaux (6) et qui empêche la formation dans le substrat semi-conducteur (1) de canaux conducteurs entre lignes voisines.

9. Procédé selon la revendication 7 ou 8
au cours duquel les transistors MOS sont générés avec, en tant que diélectrique de grille (14), une couche diélectrique multiple qui présente, par rapport à au moins une autre couche de la couche multiple, au moins une couche ayant une section de capture des électrons plus importante.

10. Procédé selon la revendication 9
au cours duquel la couche multiple comporte au moins une couche de SiO₂ et une couche de Si₃N₄.

11. Procédé selon la revendication 7 ou 8
- au cours duquel, avant la gravure des sillons longitudinaux (6), est exécutée une première implantation de canaux pour le réglage de la tension de seuil des transistors MOS qui sont disposés entre les sillons longitudinaux (6) sur la surface principale (2),
- au cours duquel, après la gravure des sillons longitudinaux (6), est exécutée une deuxième implantation de canaux pour le réglage de la tension de seuil des transistors MOS qui sont disposés au fond des sillons longitudinaux (6), la surface principale (2) entre sillons longitudinaux voisins (6) étant masquée.

12. Procédé selon la revendication 11,
- au cours duquel la gravure des sillons longitudinaux (6) se fait en utilisant, en tant que masque de gravure, un masque de sillons (5) contenant du SiO₂,
- au cours duquel, lors de la deuxième implantation de canaux, le masque de sillons (5) contenant du SiO₂ masque la surface principale (2) entre sillons longitudinaux voisins (6),
- au cours duquel le masque de sillons (5) est enlevé après la deuxième implantation de canaux.

13. Procédé selon l'une des revendication 7 à 12
- au cours duquel, pour la formation des conducteurs de mots (19) après l'enlèvement du masque source/drain (10), après formation d'espaceurs isolants (13) sur les parois latérales des sillons longitudinaux (6) et après production d'un diélectrique de grille (14), une couche conductrice oxydable (15) est déposée sur toute la surface et, sur celle-ci, une couche de nitrure de silicium (16),
- au cours duquel sont formés, par décapage anisotrope, des espaceurs en nitrure de silicium (17) à partir de la couche de nitrure de silicium (16),
- au cours duquel des zones à nu de la couche conductrice (15) sont recouvertes par oxydation d'un masque d'oxyde (18),
- au cours duquel les espaceurs en nitrure de silicium (17) sont enlevés,
- au cours duquel les conducteurs de mots (19) sont formés par structuration de la couche conductrice (15), au cours d'un processus de décapage qui utilise le masque d'oxyde (18) comme masque de décapage.
